# EUROPÄISCHE PATENTANMELDUNG

(11) **EP 1 152 648 A2**
(43) Veröffentlichungstag der Anmeldung: **07.11.2001**
(21) Anmeldenummer: 01107867.2
(22) Anmeldetag: 10.04.2001
(51) Int. Cl.: H05K 5/00

(54) **Gehäuse und Verfahren zu dessen Herstellung**

(30) Priorität: 11.04.2000 DE 10018020
(71) Anmelder: Cherry GmbH, 91275 Auerbach (DE)
(72) Erfinder: Bauer, Günter, 92237 Sulzbach-Rosenberg (DE)
(74) Vertreter: Frohwitter, Bernhard, Dipl.-Ing.

(57) **Zusammenfassung**

Es wird ein Gehäuse 11, insbesondere für eine elektrische Schaltungsanordnung 1 in Schließvorrichtungen in Kraftfahrzeugen, mit einem Leiterbahngebilde 2, das mindestens einen Anschlußabschnitt 5 aufweist, der mit einem Anschlußbereich 6 eines elektrischen Bauelements 7 elektrisch verbunden ist, und mit einer Vergußmasse 10 vorgeschlagen. Die Schaltungsanordnung 1 zeichnet sich dadurch aus, daß eine Wandung 8 innerhalb des Gehäuses 11 im Bereich des Anschlußabschnitts 5 und des Anschlußbereichs 6 eines elektrischen Bauelements 7 derart angeordnet ist, daß eine Wanne 9 ausgebildet ist, in die die die Vergußmasse 10 eingegossen ist. Hierdurch sind der Anschlußabschnitt 5 und der Anschlußbereich 6 vor äußeren Einflüssen hinsichtlich Feuchtigkeit und Temperatur geschützt.

## Beschreibung

Die Erfindung betrifft ein Gehäuse, insbesondere für eine elektrische Schaltungsanordnung in Schließvorrichtungen in Kraftfahrzeugen, mit einem Leiterbahngebilde, das mindestens einen Anschlußabschnitt aufweist, der mit einem Anschlußbereich eines elektrischen Bauelements elektrisch leitend verbunden ist, und mit einer Vergußmasse, sowie ein Verfahren zur Herstellung der Schaltungsanordnung.

Elektrische Schaltungsanordnungen in Gehäusen der hier angesprochenen Art finden heutzutage in vielerlei elektrischen Geräten Verwendung. Hierbei müssen sie- je nach Gerät, für das sie vorgesehen sind - hinsichtlich ihrer Funktionssicherheit und Betriebsstabilität unterschiedlich hohen Anforderungen genügen. Bei stationär und in geschlossenen Räumen betriebenen Geräten sind hierbei naturgemäß geringere Anforderungen an die Funktionssicherheit und Betriebsstabilität der Schaltungsanordnungen zu stellen als bei Geräten, die mobil oder im Freien betrieben werden. Besonders hoch sind derartige Anforderungen unter anderem bei in Kraftfahrzeugen eingebauten Geräten, wie beispielsweise Schließvorrichtungen für die Seitentür, Heckklappe, Motorhaube oder dergleichen, da deren Schaltungsanordnungen durch mitunter auftretende extreme Außentemperaturen und Luftfeuchtigkeit, durch starke Schwankungen von Außentemperaturen und Luftfeuchtigkeit, durch in der Umgebungsluft befindliche Schmutzpartikel wie auch durch mechanische Vibration oftmals stark beansprucht sind.

Die deutsche Druckschrift DE 44 37 664 A1 schlägt in diesem Zusammenhang eine zunächst flüssige, danach aushärtende Schaumstoffmasse vor, die eine Leiterplatte, Gehäuseteile und zumindest Teile flexibler Leiterbahnen eines elektrischen Gerätes umgibt, und die zwischen diesen eine vor äußeren Einflüssen schützende mechanisch haltbare Verbindung herstellt. Nachteilig wirkt sich bei dieser Anordnung aus, daß während des Ausschäumens der mit der Schaumstoffmasse zu versehenden Teile die Schaumstoffmasse auch auf Teile gelangen kann, wo sie nicht erwünscht ist, was eine nach dem Aushärten durchzuführende Entfernung der Schaumstoffmasse von diesen Teilen erforderlich macht.

Ein gleiches Problem stellt sich beim Gegenstand der deutschen Offenlegungsschrift DE 37 06 168 A1. Hier wird ein ein Anschlußkabel eines Meßaufnehmers aufnehmendes wannenförmiges Gehäuseoberteil mit einem Kunststoff vergossen. Der Kunststoff kann auch hier auf Teile gelangen, auf denen er nicht erwünscht ist.

Es ist daher Aufgabe der Erfindung, ein Gehäuse für eine elektrische Schaltungsanordnung bereitzustellen, bei dem die Schaltungsanordnung auch bei starker Beanspruchung eine hohe Funktionssicherheit und Betriebsstabilität aufweist, und bei der zudem die Vergußmasse während des Vergießens nicht an Teile gelangt, wo sie nicht erwünscht ist. Des weiteren ist es Aufgabe der Erfindung, ein Verfahren zur Herstellung eines solchen Gehäuses zu entwickeln.

Die Aufgabe wird erfindungsgemäß durch ein Gehäuse der hier angesprochenen Art gelöst, bei dem eine Wandung im Bereich des Anschlußabschnitts und des Anschlußbereichs derart angeordnet ist, daß eine Wanne ausgebildet ist, in die die Vergußmasse eingegossen ist. Der Anschlußabschnitt und der Anschlußbereich, die durch eine Löt- oder Schweißverbindung miteinander elektrisch verbunden sind, werden durch die sie bedeckende Vergußmasse nach außen hin abgeschirmt. In der Umgebungsluft befindliche Schmutzpartikel werden von der Löt- oder Schweißverbindung, im Falle der Lötverbindung insbesondere von deren besonders empfindlichem Lötzinn, ferngehalten. Die Vergußmasse dämpft des weiteren extreme Außentemperaturen und Luftfeuchtigkeit wie auch große Schwankungen dieser Größen, so daß der Anschlußabschnitt und der Anschlußbereich weniger stark beansprucht werden. Die Verwendung einer Vergußmasse, also einer Masse, die in pastöser Form aufgetragen wird und sodann aushärtet, hat den Vorteil, daß eine optimale Anpassung an räumliche Gegebenheiten von Anschlußabschnitt und Anschlußbereich möglich ist, mithin eine optimale Bedeckung und damit Abschirmung erzielt werden kann. Ein weiterer Vorteil der Wanne kommt in dem Fall zum Tragen, wenn die Vergußmasse beim Aufbringen auf den Anschlußabschnitt und den Anschlußbereich derart flüssig ist, daß sie zerfließt, sie sich also über den Anschlußabschnitt und den Anschlußbereich hinaus über das Leiterbahngebilde ausbreitet. Das Zerfließen wird durch die Wandung der Wanne begrenzt. Eine Beschädigung anderer Bauelemente auf dem Leiterbahngebilde wird so vermieden.

Es ist bevorzugt vorgesehen, wenn das Leiterbahngebilde innerhalb der Wanne mit mindestens einem elektrischen Zusatzbauelement bestückt ist. Das Zusatzbauelement ist vollkommen von Vergußmasse umgeben. Hierdurch ist es vor äußeren Einwirkungen besonders gut geschützt, weshalb sich die Anordnung des Zusatzbauelements in der Wanne besonders für sehr empfindliche Zusatzbauelemente empfiehlt.

Ein anderes bevorzugtes Ausführungsbeispiel sieht vor, daß das Leiterbahngebilde flexibel ausgebildet ist. Durch diese - plastische oder elastische - Verformbarkeit ist es besonders einfach möglich, das Leiterbahngebilde an räumliche Gegebenheiten des Gerätes anzupassen.

Des weiteren ist bevorzugt, wenn das Leiterbahngebilde innerhalb der Wanne einen gebogenen Abschnitt aufweist. Die innerhalb der Wanne befindliche und von Vergußmasse umgebene Fläche des Leiterbahngebildes kann dadurch auf einfache Art vergrößert werden, was die Möglichkeit schafft, das Leiterbahngebilde innerhalb der Wanne mit mehreren Zusatzbauelementen zu bestücken.

Ein weiteres bevorzugtes Ausführungsbeispiel der Erfindung sieht vor, das die Schaltungsanordnung in einem Gehäuse untergebracht ist. Das Gehäuse stellt ein zusätzliches einfaches Mittel dar, die Schaltungsanordnung vor äußeren Einwirkungen abzuschirmen.

Wieder ein anderes bevorzugtes Ausführungsbeispiel der Erfindung sieht vor, daß die Wandung als Teil des Gehäuses ausgebildet ist. Bei dieser Ausgestaltung müssen vorteilhafterweise keine eigenen Bauteile dafür vorgesehen werden, die Wandung in ihrer räumlichen Lage zu halten. Die Wanne ist bei dieser Ausgestaltung ein Teil des Gehäuses.

Ein weiteres bevorzugtes Ausführungsbeispiel der Erfindung sieht vor, daß das Gehäuse mindestes einen Fixiervorsprung aufweist, der eine Fixieröffnung des Leiterbahngebildes durchgreift. Diese Ausgestaltung bringt zwei Vorteile mit sich. Zum einen wird die Montage des Leiterbahngebildes in dem Gehäuse vereinfacht. Das Leiterbahngebilde muß nur derart in das Gehäuse eingelegt werden, daß der Fixiervorsprung die Fixieröffnung durchgreift. Zum anderen wird bei dieser Ausgestaltung das Leiterbahngebilde bei Betrieb des Gerätes, insbesondere bei Einwirkung von Vibrationen, sicher in seiner Lage gehalten. Es kann vorgesehen sein, daß der Fixiervorsprung einen durch Heiß- oder Kaltverstemmen erzeugten Kopf aufweist, der größer bemessen ist als die Fixieröffnung, wodurch das Leiterbahngebilde unverlierbar in dem Gehäuse gehalten ist.

Bevorzugt vorgesehen ist ebenfalls, wenn das Gehäuse mindestens einen Aufnahmeabschnitt aufweist, der einen Haltebereich des Bauelements aufnimmt. Hierdurch wird erreicht, daß das Bauelement fest in seiner Lage gehalten wird.

Schließlich ist bevorzugt vorgesehen, wenn das Leiterbahngebilde mehrere Lagen umfaßt und/oder mindestens eine Lage des Leiterbahngebildes die Leiterbahnen aufweist und/oder mindestens eine der Lagen als Isolierlage ausgebildet ist. Bei dieser Ausgestaltung ist das Leiterbahngebilde als Multilayer-Leiterbahngebilde ausgebildet. Steht die Isolierlage mit der Vergußmasse in Berührkontakt, so ist die Leiterbahnen aufweisende Lage des Leiterbahngebildes besonders geschützt. Eine Beschädigung der Leiterbahnen, insbesondere beim Einbringen der Vergußmasse in die Wanne kann so auf einfache Weise vermieden werden.

Die Aufgabe wird des weiteren durch ein Verfahren zur Herstellung eines Gehäuses, insbesondere nach einem der Einsprüche 1 bis 11, gelöst, das durch folgende Schritte gekennzeichnet ist: (a) Herstellen der elektrischen Verbindung zwischen dem Leiterbahngebilde und dem elektrischen Bauelement, (b) Einsetzen des Leiterbahngebildes in das Gehäuse und (c) Ausgießen der Wanne durch Einbringen der Vergußmasse in die Wanne.

Weitere Ausgestaltungen der Erfindung sowie deren Vorteile ergeben sich aus der Zeichnung.

Die Erfindung wird im folgenden anhand einer Zeichnung näher erläutert. Es zeigen
- Figur 1: die Erfindung in einer schematisierten Draufsicht,
- Figur 2: einen Schnitt (Schnittebene A) durch die Erfindung nach Figur 1 und
- Figur 3: zwei weitere Schnitte (Schnittebenen B und C) durch die Erfindung nach Figur 1.

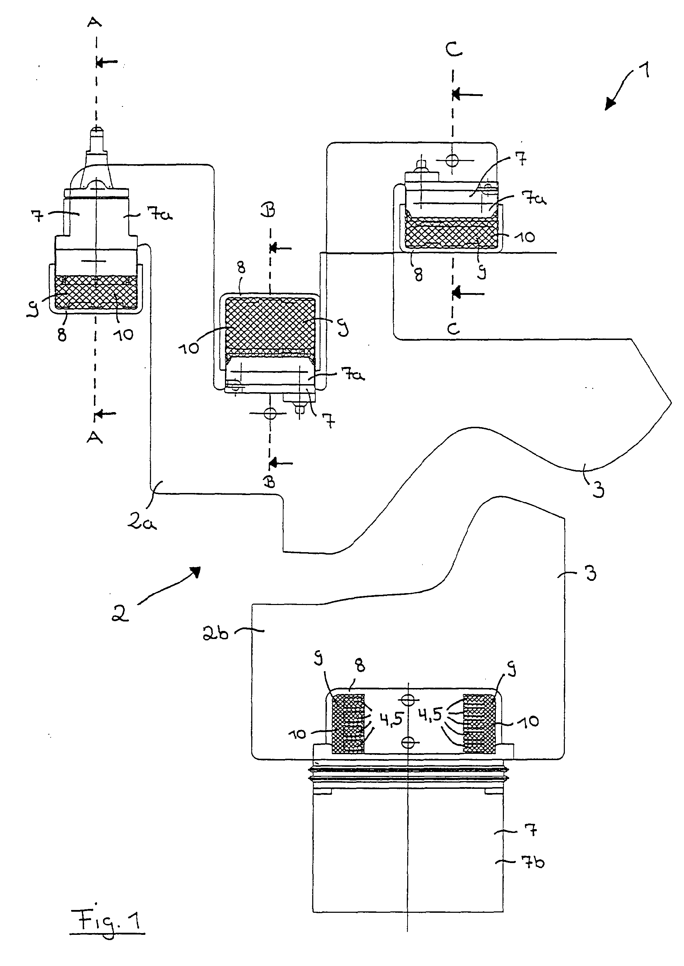

Figur 1 zeigt eine elektrische Schaltungsanordnung 1, wie sie beispielsweise in Schließvorrichtungen für die Seitentür, Heckklappe, Motorhaube oder dergleichen von Kraftfahrzeugen zum Einsatz kommt.

Die Schaltungsanordnung 1 umfaßt ein Leiterbahngebilde 2, von dem im Figur 1 zwei Ausschnitte 2a und 2b dargestellt sind. Das Leiterbahngebilde 2 ist als flexibles, folienartiges, mehrere Lagen 3 aufweisendes Leiterbahngebilde 2 ausgebildet. Die Lagen 3 des Leiterbahngebildes 2 sind als Isolierlagen und als Leiterbahnen aufweisende Lagen ausgebildet. Die Isolierlage weist Öffnungen auf, so daß die Leiterbahnen der Leiterbahnen aufweisenden Lage von außen zugänglich sind. Im Bereich der Öffnungen münden die Leiterbahnen in als Lötpads 4 ausgebildete Anschlußabschnitte 5, an denen eine elektrische Verbindung mit in Figur 1 nicht sichtbaren Anschlußbereichen 6 von elektrischen Bauelementen 7 hergestellt ist.

Die elektrischen Bauelemente 7 der Schaltungsanordnung 1 sind als Schalter 7a und Stecker 7b ausgebildet. Die Verbindung zwischen den Anschlußabschnitten 5 des Leiterbahngebildes 2 und den Anschlußbereichen 6 der elektrischen Bauelemente 7 ist als Lötverbindung ausgebildet.

Die Schaltungsanordnung 1 ist in einem in Figur 1 nicht dargestellten Gehäuse 11 untergebracht, von dem in Figur 1 nur Wandungen 8 sichtbar sind. Die Wandungen 8 sind im Bereich der Anschlußabschnitte 5 und der Anschlußbereiche 6 derart angeordnet, daß sie zusammen mit den elektrischen Bauelementen 7 jeweils einseitig offene Wannen 9 bilden. Die Wannen 9 nehmen eine Vergußmasse 10 auf, durch die sie gänzlich ausgefüllt werden. Innerhalb der Wannen 9 bedeckt die Vergußmasse 10 die Anschlußabschnitte 5, die Anschlußbereiche 6 sowie Teile der Isolierlage des Leiterbahngebildes 2.

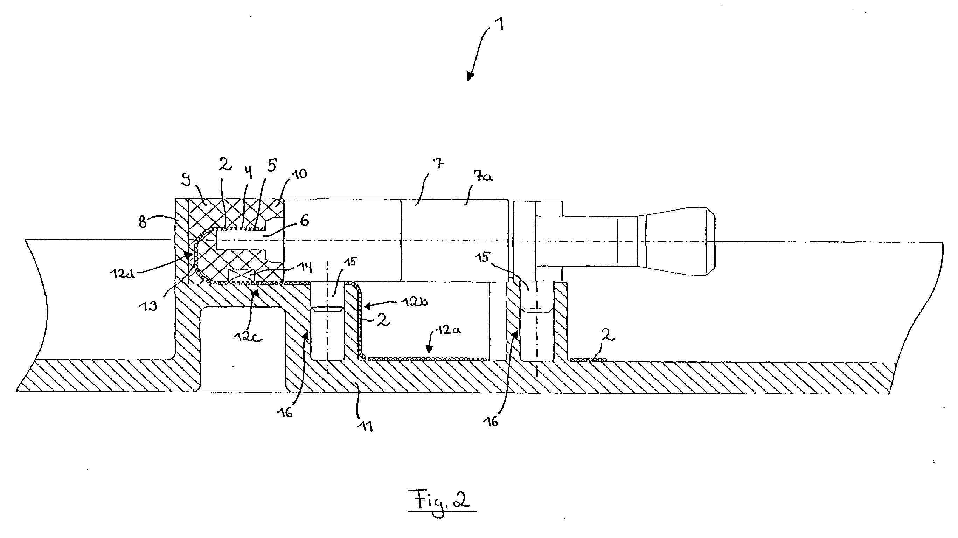

Figur 2 zeigt die Schaltungsanordnung 1 in einer Schnittdarstellung bezüglich der Ebene A. In dieser Figur ist das aus Kunststoff gefertigte Gehäuse 11 zu erkennen, von dem ein Teil die Wandung 8 der Wanne 9 bildet.

Des weiteren wird aus dieser Figur deutlich, daß das Leiterbahngebilde 2 nicht in einer Ebene angeordnet ist. So verläuft es in einer ersten Zone 12a der Schaltungsanordnung 1 entlang der Oberfläche des Gehäuses 11 und in einer zweiten Zone 12b entlang der Außenfläche eines in dem Gehäuse 11 ausgebildeten Fixiervorsprungs 13. In einer dritten Zone 12c erstreckt sich das Leiterbahngebilde 2 - in etwa parallel zu seiner Verlaufsrichtung in der Zone 12a - durch den unteren Bereich der Wanne 9. Im Anschluß daran weist das Leiterbahngebilde 2 in einer Zone 12d einen gebogenen Abschnitt 13 auf. Das Leiterbahngebilde 2 endet in dem Anschlußabschnitt 5. Es ist unmittelbar erkennbar, daß sich das Leiterbahngebilde 2 durch seine flexible Ausbildung an beliebige durch das Gehäuse 11 oder die elektrischen Bauelemente 7 vorgegebene räumliche Gegebenheiten anpassen kann.

Das Leiterbahngebilde 2 ist in der dritten Zone 12c mit einem elektrischen Zusatzbauelement 14 bestückt. Das Zusatzbauelement ist ein oberflächenmontierter Widerstand. Andere Bauelemente, insbesondere mit Drahtanschlüssen versehene Bauelemente können jedoch ebenfalls als Zusatzbauelemente 14 in Frage kommen.

In Figur 2 ist zu erkennen, daß die Wanne 9 durch die Wandung 8, das Gehäuse 11 und das Bauelement 7 gebildet ist. Der Anschlußbereich 6 des elektrischen Bauelements 7 erstreckt sich von dem Bauelement 7 weg in das Innere der Wanne 9 hinein, wo er mit dem Anschlußabschnitt 5 des Leiterbahngebildes 2 durch eine Lötverbindung elektrisch verbunden ist.

Das Innere der Wanne 9 ist gänzlich mit der Vergußmasse 10 ausgefüllt. Dadurch sind das Zusatzbauelement 14, der gebogene Abschnitt 13 des Leiterbahngebildes 2, der Anschlußabschnitt 5 des Leiterbahngebildes 2 sowie der Anschlußbereich 6 des Bauelements 7 gänzlich von der Vergußmasse 10 bedeckt bzw. umhüllt. Als Vergußmasse 10 findet Epoxidharz Verwendung, das in gelartiger bzw. pastöser Form in die Wanne 9 eingespritzt wird und anschließend in der Wanne 9 aushärtet.

In Figur 2 ist gut zu sehen, auf welche Art das Bauelement 7 in dem Gehäuse 11 befestigt ist. Es weist hierzu zwei Haltebereiche 14 auf, die sich von dem Grundkörper des Bauelementes 7 weg erstrecken und in in dem Gehäuse 11 ausgebildete Aufnahmeabschnitte 16 eingreifen. Diese Anordnung gewährleistet, daß das Bauelement 7 durch das Gehäuse 11 sicher gehalten ist.

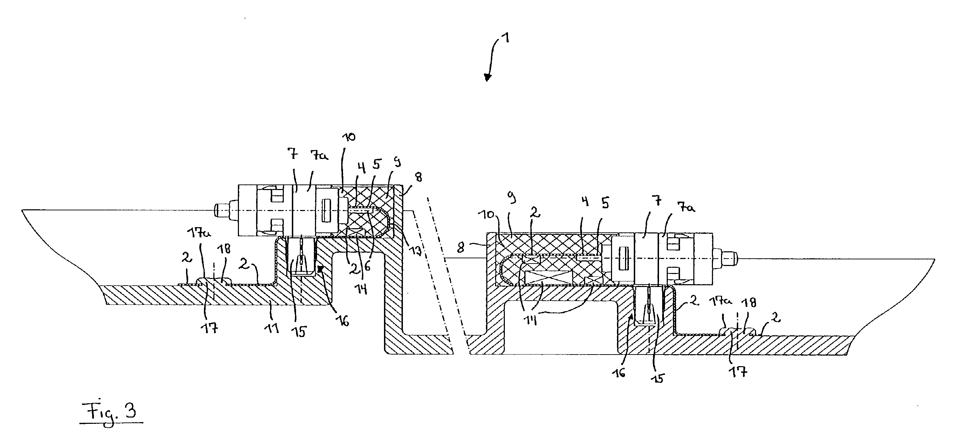

Die Figur 3 zeigt in zwei Teilfiguren zwei weitere Schnitte durch die Schaltungsanordnung 1. Die Schaltungsanordnung 1 weist mehrere in dem Gehäuse 11 ausgebildete Fixiervorsprünge 17 auf. Die Fixiervorsprünge 17 durchgreifen Fixieröffnungen 18 des Leiterbahngebildes 2 und enden in durch Heiß- oder Kaltverstemmen erzeugten Köpfen 17a, die größer bemessen sind als die Fixieröffnungen 18, so daß das Leiterbahngebilde 2 unverlierbar durch das Gehäuse 11 gehalten ist. Die Anordnung aus den Fixiervorsprüngen 17 und den Fixieröffnungen 18 dient zum einen als Hilfe für den Einbau des Leiterbahngebildes 2 in das Gehäuse 11, zum anderen gewährleistet es einen sicheren Halt des Leiterbahngebildes 2 in dem Gehäuse 11.

Die rechte Teilfigur von Figur 3 macht deutlich, daß bei entsprechender Bemessung der Wanne 9 das Leiterbahngebilde 2 innerhalb der Wanne 9 auch mit mehreren Zusatzbauelementen 14 bestückt sein kann.

## Patentansprüche

1. Gehäuse, insbesondere für eine elektrische Schaltungsanordnung in Schließvorrichtungen in Kraftfahrzeugen, mit einem Leiterbahngebilde, das mindestens einen Anschlußabschnitt aufweist, der mit einem Anschlußbereich eines elektrischen Bauelements elektrisch verbunden ist, und mit einer Vergußmasse, **dadurch gekennzeichnet, daß** eine Wandung (8) innerhalb des Gehäuses (11) im Bereich des Anschlußabschnitts (5) und des Anschlußbereichs (6) eines elektrischen Bauelements (7) derart angeordnet ist, daß eine Wanne (9) ausgebildet ist, in die die Vergußmasse (10) eingegossen ist.

2. Gehäuse nach dem vorhergehenden Anspruch, **dadurch gekennzeichnet, daß** das Leiterbahngebilde (2) innerhalb der Wanne (9) mit mindestens einem elektrischen Zusatzbauelement (14) bestückt ist.

3. Gehäuse nach einem der vorhergehenden Ansprüche, **dadurch gekennzeichnet, daß** das Leiterbahngebilde (2) flexibel ausgebildet ist.

4. Gehäuse nach einem der vorhergehenden Ansprüche, **dadurch gekennzeichnet, daß** das Leiterbahngebilde (2) innerhalb der Wanne (9) einen gebogenen Abschnitt (13) aufweist.

5. Gehäuse nach einem der vorhergehenden Ansprüche, **dadurch gekennzeichnet, daß** die Schaltungsanordnung (1) in einem Gehäuse (11) untergebracht ist.

6. Gehäuse nach einem der vorhergehenden Ansprüche, **dadurch gekennzeichnet, daß** die Wandung (8) als Teil des Gehäuses (11) ausgebildet ist.

7. Gehäuse nach einem der vorhergehenden Ansprüche, **dadurch gekennzeichnet, daß** das Gehäuse (11) mindestens einen Fixiervorsprung (17) aufweist, der eine Fixieröffnung (18) des Leiterbahngebildes (2) durchgreift.

8. Gehäuse nach einem der vorhergehenden Ansprüche, **dadurch gekennzeichnet, daß** das Gehäuse (11) mindestens einen Aufnahmeabschnitt (16) aufweist, der einen Haltebereich (15) des Bauelements (7) aufnimmt.

9. Gehäuse nach einem der vorhergehenden Ansprüche, **dadurch gekennzeichnet, daß** das Leiterbahngebilde (2) mehrere Lagen (3) umfaßt.

10. Gehäuse nach einem der vorhergehenden Ansprüche, **dadurch gekennzeichnet, daß** mindestens eine Lage (3) des Leiterbahngebildes (2) die Leiterbahnen aufweist.

11. Gehäuse nach einem der vorhergehenden Ansprüche, **dadurch gekennzeichnet, daß** eine der Lagen (3) als Isolierlage ausgebildet ist.

12. Verfahren zur Herstellung eines Gehäuses für eine elektrische Schaltungsanordnung, insbesondere nach einem der Ansprüche 1 bis 11, **gekennzeichnet durch** die folgenden Schritte: (a) Herstellen einer elektrischen Verbindung zwischen dem Leiterbahngebilde (2) und dem Bauelement (7), (b) Einsetzen des Leiterbahngebildes (2) in das Gehäuse (11) und (c) Einbringen der Vergußmasse (10) in die Wanne (9).
